# EUROPÄISCHE PATENTANMELDUNG

(11) **EP 0 725 462 A1**
(43) Veröffentlichungstag der Anmeldung: **07.08.1996**
(21) Anmeldenummer: 96101122.8
(22) Anmeldetag: 26.01.1996
(51) Int. Cl.: H01S 3/133, H01S 3/25

(54) **Regelung zweier Werte der von einer Laserdiode abgegebenen optischen Leistung unter Einsatz nur eines Reglers**

(30) Priorität: 02.02.1995 DE 19503410
(71) Anmelder: SIEMENS AKTIENGESELLSCHAFT, 80333 München (DE)
(72) Erfinder: Gruhler, Ulrich, Dipl.-Ing., D-80689 München (DE); Schreck, Hans-Günther, Dipl.-Ing., D-80801 München (DE)

(57) **Zusammenfassung**

Es wird eine Regelung der Leistung des von einer Laserdiode abgegebenen optischen Signals angegeben, bei der sowohl ein niedriger optischer Pegel als auch ein hoher optischer Pegel unter Einsatz nur eines Reglers konstant gehalten wird. Eine besondere Ausgestaltung ist durch eine Master-Slave-Anordnung gegeben, bei der die für eine mit niedriger Frequenz betriebene Master-Laserdiode ermittelten Stellgrößen auch für eine Anzahl von mit hoher Datenrate betriebenen Slave-Laserdioden genutzt werden. In weiterer Ausgestaltung ist der Regler in digitaler Schaltungstechnik ausgeführt.

## Beschreibung

Der Anmeldungsgegenstand betrifft ein Verfahren und eine Schaltungsanordnung zur Regelung der Leistung des von einer Laserdiode abgegebenen optischen Signals wobei
- eine erste Laserdiode zusammen mit einer Fotodiode und einem Regler einen Regelkreis bilden und
- der Regelkreis auf den Sollwert des niedrigen optischen Pegels einregelbar ist.

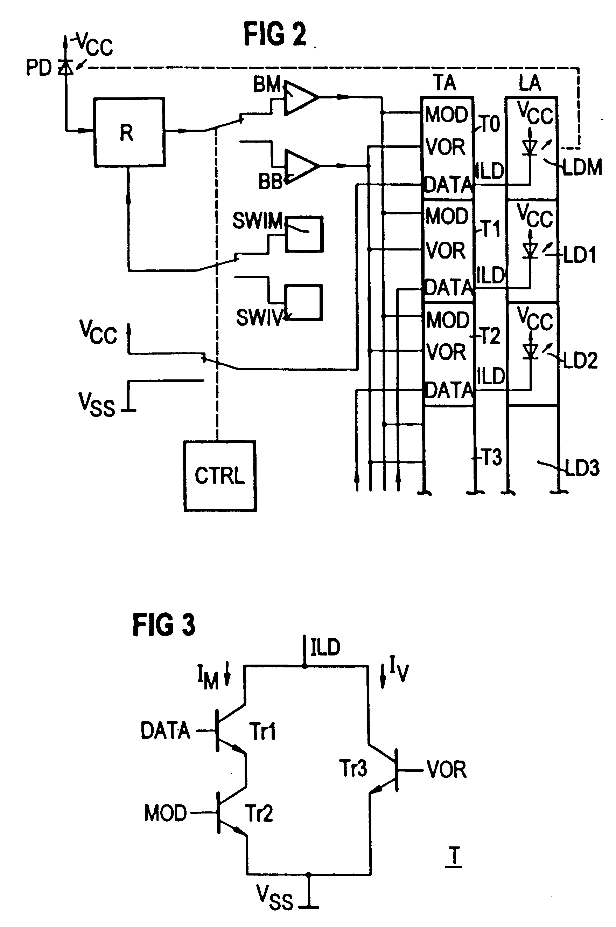

Ein solches Verfahren und eine solche Schaltungsanordnung ist aus H. Rokugawa et al., 'Multigigabit-per-Second Optical Parallel Transmitter Module Using a 4-Channel Laser Diode Array with a Wide Temperature Range Operation', European Conference on Optical Communications 1992, TuP 1.11, pp. 265-268 bekannt. In dem dort in Fig 3 dargestellten Regelkreis wird, wie dem zugehörigen Text unter Punkt 3 zu entnehmen ist, entweder der Vorstrom oder der Modulationsstrom einer Laserdiode geregelt.

Fur einen Empfänger ist bei Empfang eines von einer Laserdiode abgegebenen optischen Signals das als Modulationsgrad bezeichnete Verhältnis von niedrigem optischem Leistungspegel zu hohem optischem Leistungspegel maßgebend. Bei einer Datenübertragung mit einer hohen Datenrate ist eine Übertragung im NRZ (Non-Return-to-Zero) - Format erforderlich. Im NRZ - Format werden die beiden logischen Zustände als niedriger, jedoch von Null abweichender, und als hoher optischer Pegel dargestellt. Mit Alterung und Änderung der Temperatur der Laserdiode verändern sich sowohl der Schwellstrom als auch die Steilheit ihrer Übertragungskennlinie. Wird, wie bei dem Gegenstand nach dem angegebenen Stand der Technik, lediglich eine der beiden Größen geregelt, so ist mit Alterung und/oder Änderung der Temperatur der Laserdiode eine Abnahme des Modulationsgrades hinzunehmen, was zur Verringerung der Reichweite führt.

Zur Regelung sowohl des Vorstromes als auch des Modulationsstromes sind mit zwei Regelkreisen gebildete Regler, wie das Pilotton- und das Modulationshubextraktionsverfahren bekannt geworden. Diese Verfahren werden bevorzugt bei Einzellasern in der Weitverkehrstechnik eingesetzt, wo der hohe Aufwand nicht so sehr ins Gewicht fällt.

Dem Anmeldungsgegenstand liegt das Problem zugrunde, ein Verfahren und eine Schaltungsanordnung für eine Laserdiode anzugeben, bei denen zwei gleichzeitig benötigte Werte der von einer Laserdiode abgegebenen optischen Leistung mit nur einem Regelkreis nachführbar sind.

Das Problem wird bei einem eingangs umrissenen Verfahren bzw. einer Schaltungsanordnung dadurch gelöst, daß der Eingang des Reglers vom Sollwert für den niedrigen optischen Pegel auf den Sollwert für den hohen optischen Pegel und der Ausgang des Reglers von der Stellgröße für den den niedrigen optischen Pegel bewirkenden Vorstrom auf die Stellgröße für den den hohen optischen Pegel bewirkenden Modulationsstrom umschaltbar sind, während die Stellgröße für den Vorstrom konstant gehalten wird.

Der Anmeldungsgegenstand macht sich die Erkenntnis zu Nutze, daß die langsame Veränderung der Parameter der Laserdiode eine sequentielle Regelung der beiden Werte zulassen. Der Anmeldungsgegenstand bringt durch Nachführung sowohl des Vorstromes als auch des Modulationsstromes eine Konstanthaltung des Modulationsgrades wie eine Zweikreisregelung, jedoch bei einem geringen schaltungstechnischen Aufwand mit sich.

In weiterer Ausgestaltung sind weitere, zu der ersten Laserdiode gleiche Laserdioden unter den gleichen Umgebungsbedingungen angeordnet, wobei die weiteren Laserdioden nach Maßgabe der in dem Regelkreis für die erste Laserdiode ermittelten Stellgrößen gesteuert werden. Bei dieser Master-Slave Anordnung ist nur eine Regelung für sämtliche Laserdioden gegeben, womit sich der anteilige Aufwand je Laserdiode mit steigender Anzahl der Laserdioden verringert. Die als Master gegebene erste Laserdiode kann frei von zu übertragenden Daten gehalten werden, womit die Daten selbst frei von einer möglicherweise erforderlichen besonderen Codierung gehalten werden können. Ist die erste Laserdiode frei von einer Datenübertragung, so können die Regelvorgänge mit einer niedrigen Frequenz erfolgen, wobei eine Fotodiode mit niedriger oberer Grenzfrequenz einsetzbar ist und der Regelkreis mit einfachen Mitteln, wie z.B. mit Filtern gegen hochfrequente Störungen, die möglicherweise auf die Datenübertragung zurückzuführen sind, geschützt werden können. Bei den als Slave bezeichneten weiteren Laserdioden, die jeweilige Daten mit hoher Datenrate zu übertragen vermögen, ist eine Auskopplung eines Teiles der abgegebenen optischen Leistung auf eine Focodiode nicht erforderlich, womit die gesamte abgegebene optische Leistung für die Übertragung zur Verfügung steht.

In weiterer Ausgestaltung ist die Schaltungsanordnung in digitaler Schaltungstechnik ausgeführt. Diese Maßnahme bringt eine einfache Zuführbarkeit der Sollwerte in Form von Digitalworten mit sich und bedarf keiner ansonsten in analoger Schaltungstechnik erforderlichen Temperaturkompensation des Reglers.

In weiterer Ausgestaltung erfolgt die Umschaltung nach Maßgabe eines eine niedrige Datenrate aufweisenden Datensignals, das von der ersten Laserdiode weitergeleitet wird. Diese Maßnahme bringt eine Ausnutzung der im Master-Slave-Betrieb zur Datenübertragung nicht genutzten ersten Laserdiode zur Übertragung von Daten mit niedriger Datenrate mit sich. Diesem Prinzip kommt selbständige Bedeutung zu.

Der Anmeldungsgegenstand wird im folgenden als Ausführungsbeispiel in einem zum Verständnis erforderlichen Umfang anhand von Figuren näher beschrieben. Dabei zeigen:
- Figur 1: eine typische Strom - Leistungs - Kennlinie einer Laserdiode,
- Figur 2: eine Schaltungsanordnung, die vom Anmeldungsgegenstand Gebrauch macht,
- Figur 3: nähere Einzelheiten einer Treiberschaltung T aus Figur 2.

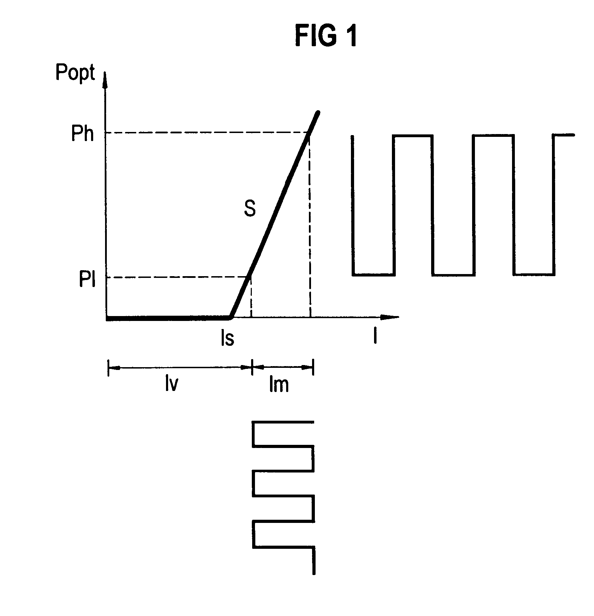

Figur 1 zeigt den hinlänglich bekannten Zusammenhang zwischen dem von einer Laserdiode aufgenommenen Strom I und der von der Laserdiode abgegebenen optischen Leistung Popt. Bis zu einem Schwellenstrom Is gibt die Laserdiode keine nennenswerte optische Leistung ab. Für steigende Stromwerte oberhalb des Schwellenstromes Is nimmt die von der Laserdiode abgegebene optische Leistung annähernd mit der Steigung S zu. Im übrigen sei auf die bekannte, nicht näher dargestellte Tatsache hingewiesen, daß mit steigender Temperatur der Laserdiode der Schwellenstrom ansteigt und die Steilheit abnimmt. Zur Erzielung einer möglichst hohen Datenrate erfolgt die Codierung der Daten im NRZ-Format (Non Return to Zero), d.h. der eine logische Zustand wird durch Ansteuerung der Laserdiode mit dem Vorstrom Iv durch einen niedrigen optischen Pegel Pl und der andere logische Zustand durch Ansteuerung der Laserdiode mit einem um den Modulationsstrom Im erhöhten Vorstrom in ein Signal mit hoher optischer Leistung Ph umgesetzt.

In Figur 2 ist ein Teil der von der Laserdiode LDM abgegebenen optischen Leistung, wie durch eine gestrichelte Linie angedeutet, einer Fotodiode PH zugeführt. Die Fotodiode, die von der das hohe Potential führenden Klemme Vcc einer nicht näher dargestellten Betriebsspannungsquelle Vcc-Vss gespeist ist, führt ein Signal, das dem von der Laserdiode abgegebenen optischen Signal entspricht einem Eingang eines Reglers R zu. Einem weiteren Eingang des Reglers ist als Stellgröße über einen Umschalter der Sollwert SWIV für den Vorstrom oder der Sollwert SWIM für den Modulationsstrom zugeführt. Der Ausgang des Reglers ist über einen Umschalter entweder mit dem Halteglied BM (für: Buffer Modulationsstrom) zur Speicherung der Stellgröße des Modulationsstromes oder mit einem Halteglied BB (für: Buffer Bias) zur Speicherung der Stellgröße für den Vorstrom verbunden. Die Ausgänge der Halteglieder BM und BB sind mit entsprechenden Eingängen MOD bzw. VOR einer Treiberschaltung T0 verbunden. Die Treiberschaltung liefert den Vorstrom und den Modulationsstrom für die zugehörige Laserdiode.

Figur 3 zeigt eine mögliche Ausgestaltung einer Treiberschaltung. Der Serienschaltung eines Transistors Tr1 und eines Transistors Tr2 ist ein Transistor Tr3 parallelgeschaltet. Die Parallelschaltung ist mit ihrer den Emittern zugewandten Verbindung mit der das niedrige Potential aufweisenden Klemme Vss der Betriebsspannungsquelle verbunden. Die den Kollektoren zugewandte Verbindung der Parallelschaltung ist mit der Katode der zugehörigen Laserdiode verbunden. Durch den Zweig der Parallelschaltung mit dem Transistor Tr3 fließt der Vorstrom Iv, dessen Höhe über die Steuerelektrode des Transistors Tr3 einstellbar ist. Der Modulationsstrom Im fließt durch den Zweig der Parallelschaltung mit der Serienschaltung der Transistoren Tr1 und Tr2. An der Steuerelektrode des Transistors Tr2 ist die Höhe des Modulationsstromes einstellbar. An der Steuerelektrode DATA des Transistors Tr1 ist der Modulationsstrom ein- bzw. ausschaltbar.

Zurückkommend zu Figur 2 mögen die drei Umschalter, wie mit einer gestrichelten Linie angedeutet, durch eine Ablaufsteuerung CTRL zunächst in die untere Schaltposition gebracht sein. Dabei ist die Laserdiode LDM, die Fotodiode PD, der Regler R, das Halteglied BB und die zugehörige Treiberschaltung TO zu einem Regelkreis geschlossen, dem Regler ist der Sollwert für den Vorstrom zugeführt. Eine eventuell vorhandene Stellgröße für den Modulationsstrom ist nicht wirksam, da der Modulationsstrom durch den hochohmig geschalteten Transistor Tr1 unterbunden ist. Der Regelkreis regelt also den Vorstrom in Höhe des Sollwertes für den Vorstrom ein. Das Halteglied BB, das mit einer Sample-and-Hold-Schaltung gebildet sein kann, hält die Stellgröße für den Vorstrom bei. In einem folgenden Schritt bringt die Ablaufsteuerung die Umschalter, die vorzugsweise mit elektronischen Schaltmitteln gebildet sein mögen, in die obere Schaltposition. Nun bildet die Laserdiode LDM, die Fotodiode, der Regler, das Halteglied BM und die Treiberschaltung TO einen Regelkreis, dem Regler ist die Sollgröße SWIM für den Modulationsstrom zugeführt. Der Transistor Tr1 ist leitend geschaltet, womit der Modulationsstrom Im fließen kann. Die Höhe des Modulationsstromes wird vom Regelkreis so eingestellt, daß der Sollwert für die hohe optische Leistung Ph erreicht ist. Neben der betrachteten Laserdiode LDM ist eine Anzahl weiterer Laserdioden LD1..LD3 angeordnet, die den gleichen Umgebungsbedingungen ausgesetzt sind, wie die betrachtete Laserdiode LDM. Gleiche Umgebungsbedingungen können beispielsweise durch eine enge räumliche Anordnung der laserdioden zueinander gegeben sein. Gleiche Umgebungsbedingungen sind insbesondere bei einem Laserdiodenarray gegeben, bei dem mehrere Laserdioden zu einer Gruppe von Laserdioden angeordnet sind. Die Laserdioden sind durch zugehörige Treiberschaltungen T1..T3 angesteuert. Die einzelnen Treiberschaltungen können zu einem Treiberarray TA zusammengefaßt sein, bei dem mehrere gleiche Treiberschaltungen zu einer Gruppe zusammengefaßt sind. Die Treiberschaltungen sämtlicher Laserdioden sind eingangsseitig mit der von dem Halteglied BB und dem von dem Halteglied BM abgegebenen Stellgrößen beaufschlagt. Die Laserdioden LD1..LD3 leiten Datensignale mit hoher Datenrate weiter. Die Ablaufsteuerung bewirkt eine Nachregelung der Stellgrößen für den Vorstrom und den Modulationsstrom mit einer gegenüber der hohen Datenrate erheblich niedrigeren Frequenz.

Der Regler kann in digitaler Schaltungstechnik realisiert sein. Dies kann durch einen entsprechend programmierten, programmierbaren Logikbaustein, wie z.B. einen EPLD oder FPGA erfolgen. Einem in digitaler Schaltungstechnik realisierten Regler können die Sollwerte für den Vorstrom und den Modulationsstrom in einfacher Weise als Digitalworte zugeführt sein. Das von der Fotodiode abgegebene Signal wird in einem handelsüblichen Analog/Digital-Wandler umgesetzt. Bei Anordnung eines handelsüblichen Digital/Analog-Wandlers auf der dem Regler zugewandten Seite des Umschalters genügt ein Digital/Analog-Wandler; eine Anordnung auf der dem Regler abgewandten Seite des Umschalters erfordert zwei Digital/Analog-Wandler, wobei gegebenenfalls die Halteglieder entfallen können. Der Regler und die Ablaufsteuerunng können in dem programmierbaren Logikbaustein zusammengefaßt sein, wobei die Umschaltung der Regelkreise und die Bereitstellung des für die Umschaltung benötigten Taktsignales innerhalb des Logikbausteins erfolgen kann. Der Logikbaustein kann das zum Betrieb des Analog/Digital-Wandlers benötigte Taktsignal liefern. Die benötigten Referenzspannungen sind aus den von dem Digital/Analog-Wandler und dem Analog/Digital-Wandler gelieferten Referenzspannungen ableitbar.

## Patentansprüche

1. Verfahren zur Regelung der Leistung der Leistung des von einer Laserdiode abgegebenen optischen Signals demzufolge
- einem Regler (R) eingangsseitig ein der Leistung entsprechendes Signal und ein Sollwert (SWIV) für den niedrigen optischen Pegel (Pl) zugeführt werden,
- die vom Regler ausgangsseitig abgegebene Stellgröße für den Vorstrom (IV) die Einstellung des niedrigen optischen Pegels bewirkt,
**dadurch gekennzeichnet,** daß
- die Stellgröße für den Vorstrom gehalten wird,
- dem Regler anstelle des Sollwertes für den niedrigen optischen Pegel ein Sollwert für den hohen optischen Pegel (Ph) zugeführt wird, und
- die vom Regler ausgangsseitig abgegebene Stellgröße für den Modulationsstromes (Im) die Einstellung des hohen optischen Pegels bewirkt.

2. Schaltungsanordnung zur Regelung der Leistung des von einer Laserdiode abgegebenen optischen Signals, bei der
- eine erste Laserdiode zusammen mit einer Fotodiode und einem Regler einen Regelkreis bilden,
- der Regelkreis auf den Sollwert des niedrigen optischen Pegels einregelbar ist,
**dadurch gekennzeichnet,**
daß die vom Regler abgegebene Stellgröße des Vorstromes für den niedrigen optischen Pegel in einem ersten Halteglied (BB) speicherbar ist, und der Regler eingangsseitig auf den Sollwert des hohen optischen Pegels und ausgangsseitig auf die Klemme (MOD) für die Stellgröße des den hohen optischen Pegel bewirkenden Modulationsstromes umschaltbar ist.

3. Schaltungsanordnung nach Anspruch 2,
**dadurch gekennzeichnet,** daß
- eine Anzahl von zu der ersten Laserdiode gleichen weiteren Laserdioden angeordnet sind, die den gleichen Umgebungsbedingungen ausgesetzt sind, wie die erste Laserdiode,
- die Stellgröße für den Modulationsstrom in einem zweiten Halteglied (BM) speicherbar ist und
- sämtliche Laserdioden mit der Stellgröße für den Vorstrom und der Stellgröße für den Modulationsstrom beaufschlagbar sind.

4. Schaltungsanordnung nach Anspruch 2 oder 3,
**dadurch gekennzeichnet,**
daß die erste Laserdiode und die weiteren Laserdioden Teil eines Laserdiodenarrays sind.

5. Schaltungsanordnung nach einem der Ansprüche 2 bis 4, **dadurch gekennzeichnet,**
daß der Regler in digitaler Schaltungstechnik ausgeführt ist, wobei dem Regler die Sollwerte als Digitalworte und das von der Fotodiode gelieferte Signal über einen Analog/Digital-Wandler zuführbar sind.

6. Schaltungsanordnung nach Anspruch 5,
**dadurch gekennzeichnet,**
daß der Regler mit einem entsprechend programmierten programmierbaren Logikbaustein gebildet ist, der die Umschaltung bewirkt.

7. Schaltungsanordnung nach einem der Ansprüche 2 bis 6 **dadurch gekennzeichnet,**
daß die Umschaltung nach Maßgabe eines Taktsignales in niederfrequenter Wiederholung erfolgt.

8. Schaltungsanordnung nach einem der Ansprüche 3 bis 6, **dadurch gekennzeichnet,**
daß die Umschaltung nach Maßgabe eines eine niedrige Datenrate aufweisenden Datensignals, das von der ersten Laserdiode weitergeleitet wird, erfolgt.
